# FASCICULE DE BREVET EUROPEEN

(11) **EP 3 510 075 B1**
(45) Date de publication et mention de la délivrance du brevet: **01.03.2023**
(21) Numéro de dépôt: 17771825.1
(22) Date de dépôt: 11.09.2017
(51) Int. Cl.: C08G 61/12, H01L 51/00, H01L 51/42

(54) **MATÉRIAUX ACCEPTEURS ALTERNATIFS À BASE D'HEXABENZOCORONÈNE**
ALTERNATIVE AKZEPTORSTOFFE AUF DER BASIS VON HEXABENZOCORONEN
ALTERNATIVE ACCEPTOR MATERIALS BASED ON HEXABENZOCORONENE

(30) Priorité: 12.09.2016 FR 1658459
(43) Date de publication de la demande: 17.07.2019
(73) Titulaire: Centre National de la Recherche Scientifique, 75016 Paris (FR); Université de Pau et des Pays de l'Adour, 64000 Pau (FR)
(72) Inventeur: BEGUE, Didier, 64160 Serres Morlaàs (FR); HIORNS, Roger Clive, 64260 Arudy (FR); SANTOS-SILVA, Hugo, 64000 Pau (FR)
(74) Mandataire: Lavoix
(86) Numéro de dépôt international: PCT/FR2017/052398
(87) Numéro de publication internationale: WO 2018/046872

(56) Documents cités:
- WO-A1-2010/060160
- US-A1- 2016 204 348
- D. BÉGUÉ ET AL: "Graphene-based acceptor molecules for organic photovoltaic cells: a predictive study identifying high modularity and morphological stability", RSC ADVANCES: AN INTERNATIONAL JOURNAL TO FURTHER THE CHEMICAL SCIENCES, vol. 6, no. 17, 25 janvier 2016 (2016-01-25), pages 13653-13656, XP055271725, GB ISSN: 2046-2069, DOI: 10.1039/C5RA25531G
- DAVID J. JONES ET AL: "Synthesis of electron-poor hexa-peri-hexabenzocoronenes", CHEMICAL COMMUNICATIONS, vol. 48, no. 65, 6 juillet 2012 (2012-07-06), page 8066, XP055205321, ISSN: 1359-7345, DOI: 10.1039/c2cc33892k
- CHEN GAO ET AL: "Incorporation of Hexa- peri -hexabenzocoronene (HBC) into Carbazole-Benzo-2,1,3-thiadiazole Copolymers to Improve Hole Mobility and Photovoltaic Performance", CHEMISTRY - AN ASIAN JOURNAL, vol. 11, no. 5, 28 janvier 2016 (2016-01-28), pages 766-774, XP055371659, DE ISSN: 1861-4728, DOI: 10.1002/asia.201501271
- CHRISTINA M. THOMPSON ET AL: "Substituent Effects on the Gas Sorption and Selectivity Properties of Hexaphenylbenzene and Hexabenzocoronene Based Porous Polymers", MACROMOLECULES, vol. 47, no. 24, 23 décembre 2014 (2014-12-23), pages 8645-8652, XP055271594, US ISSN: 0024-9297, DOI: 10.1021/ma501663j

## Description

L'invention concerne un composé à base d'hexabenzocoronène, une couche donneur:accepteur le comprenant et un dispositif comprenant un tel composé ou une telle couche.

La demande pour des cellules photovoltaïques organiques efficaces en termes de rendement et de durée de vie est de plus en plus importante. Ces performances dépendent des caractéristiques des matériaux constitutifs. Ces matériaux doivent permettre notamment : de maximiser l'énergie solaire absorbée, de générer à partir de celle-ci des porteurs de charge électrique (électrons et trous), d'extraire ces électrons et ces trous efficacement, tout en limitant les pertes résistives, les recombinaisons et les courts-circuits.

Or, certaines de ces propriétés sont en grande partie liées à la nature de la couche active de ces dispositifs qui est constituée de paires donneur : accepteur.

Du point de vue de la performance et de la stabilité, le couple composite poly(3-hexylthiophène) :[6]-phényl-C₆₁-méthylbutyrate (P3HT:PCBM) a longtemps été un standard.
Cependant, la faible corrélation électronique entre le donneur (P3HT) et l'accepteur (PCBM), combinée avec de nombreuses instabilités morphologiques au coeur de l'hétérojonction sont deux des problèmes majeurs de cette paire donneur:accepteur.
La recherche d'une meilleure corrélation entre les propriétés électroniques va de modifications mineures de la structure chimique de l'un des composants de la paire jusqu'au remplacement complet de la molécule donneur ou de la molécule accepteur.
Dans ce contexte, les matériaux à base de graphène sont rapidement apparus comme de bons candidats accepteurs, principalement en raison de leurs remarquables propriétés semi-conductrices.

En particulier, Johns et al., dans Synthesis of electron-pour-hexa-peri-hexabenzocoronene, « Chem Commun, 2012, 48, 8066-8068*,* décrivent une série de dérivés d'hexabenzocoronène (HBC) contenant des substituants Br, F, CF₃ et aryle, qui sont dits être des accepteurs appropriés à substituer au PCBM dans le couple composite P3HT:PCBM.
Cependant, le courant de court-circuit *J*_{SC} de ce couple composite est quasi-nul, de sorte de l'efficacité des dispositifs organiques photovoltaïques (OPV) utilisant ce couple composite est également quasi-nulle. L'efficacité dépend du produit (*Voc* x *J*_{SC} x FF) divisé par la puissance entrante, où FF est le facteur de remplissage et *Voc* est la tension de circuit ouvert. De plus, le donneur et l'accepteur sont en mélange et ne sont pas connectés de façon covalente, la charge de transfert est, dès lors, gênée par la désorganisation à l'échelle du nanomètre.

Également, L. Schmidt et al., dans « Sciences », 111, 193, 2001 décrivent des systèmes colonnaires dans lesquels le donneur HBC et l'accepteur perylène sont tous deux modifiés par le greffage de chaînes alkyles en remplacement de certains des hydrogènes initialement présents. Cependant, les niveaux électroniques des entités HBC ne sont pas modifiés par le greffage des chaînes alkyles (aucune modification de l'efficacité électronique n'est, par conséquent, observée) et le donneur et l'accepteur n'ont pas non plus été liés de façon covalente pour fournir une stabilité structurelle et une auto-organisation pour optimiser la collecte des charges et leur transfert vers les électrodes.

Or, les matériaux des cellules photovoltaïques organiques doivent idéalement être adaptés et organisés pour une efficacité maximale à chaque étape du procédé de conversion de l'énergie solaire en électricité.

Récemment, les inventeurs ont publié des travaux de modélisation sur de nouveaux matériaux donneur-accepteur (Bégué et al., RSC Advances, 2006, 13653) dans lesquels ils décrivent des hexabenzocoronènes fonctionnalisés par quatre groupes carboxyliques, et auxquels un polymère conjugué a été attaché directement. Le polymère conjugué est soit P3HT soit du poly(oxypentylthiophène) (P3OPT). Selon la modélisation réalisée, cet arrangement induirait un arrangement supramoléculaire en colonnes suivant une caractéristique de cristal liquide discotique favorisant la dissociation des charges et leur transfert dans la direction de l'empilement π.

Par ailleurs, les dispositifs actuels possèdent des stabilités élevées (supérieures à 15 ans), mais nécessitent une étape d'encapsulation très coûteuse en raison de leur sensibilité à l'oxygène, de problèmes d'infiltrations d'eau et de possibles dégradations thermiques. Cela est dû au fait que les matériaux actuels sont tous trop instables en raison de leur sensibilité chimique et des modifications structurales irréversibles observées à travers la couche active.

De plus, toutes les cellules photovoltaïques organiques existantes qui ont été décrites présentent un problème de stabilité face au phénomène d'auto-oxydation.
Dans ce contexte, très récemment, la formation d'un polymère, appelé ZP46, obtenu à partir des monomères benzo[1,2-b;3,4-b]dithiophène thiéno[3,4-c]pyrrol-4,6-dione a permis d'obtenir des systèmes photochimiquement stables grâce, notamment, à une disposition spatiale compacte qui crée un effet de blindage très résistant aux attaques de l'oxygène.

Dès lors, un premier objet de l'invention est un composé à base d'hexabenzocoronène de la formule I suivante : 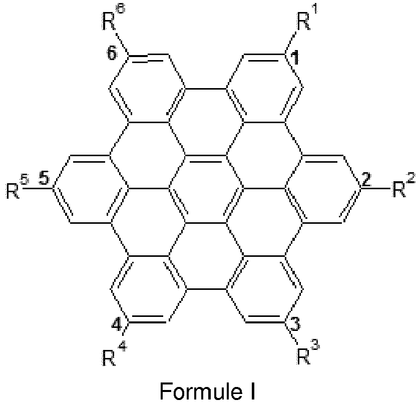 dans laquelle :
- R¹, R³, R⁴ et R⁶ sont choisis indépendamment les uns des autres, parmi un groupe carboxylique (-COOH), un group cyano (-C=N), un groupe isocyano (-N⁺≡C), un groupe cyanate (-O-C=N) et un un groupe CF₃, et
- R² et R⁵ ont la formule (1) suivante:

   X_{(n₁)}-ZP46 Formule (1)

   dans laquelle :
   ∘ X est un groupe espaceur choisi parmi un groupe -COO- et un groupe -CONH-,
   ∘ n₁ = 0 ou 1, et
   ∘ ZP46 a la formule (2) suivante : 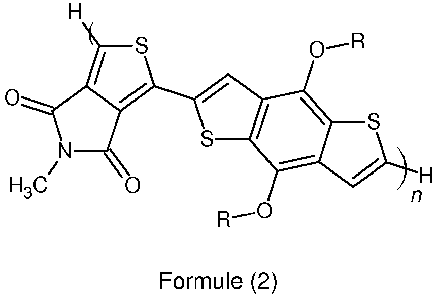
dans laquelle R est methyl ou C6H13.

Dans la formule 2, comme cela apparaîtra clairement à l'homme de l'art, n désigne le nombre d'unités récurrentes du polymère de formule (2).

Ce composé s'est révélé particulièrement adapté pour former la couche active (donneur:accepteur) d'une cellule organique photovoltaïque.

En effet, l'inclusion de ce composé qui associe un hexabenzocoronène substitué en positions 1, 3, 4 et 6 par un groupe carboxylique ou cyano ou isocyano ou cyanate ou un atome de fluor et le polymère ZP46 permet d'augmenter les propriétés de résistance à la photo-oxydation de la couche active d'un OPV, par exemple.

Dans le composé de l'invention, de préférence, les substituants en R¹, R³, R⁴ et R⁶ (les substituants en position 1, 3, 4 et 6) sont des groupes carboxyliques.

Cependant, dans un mode de réalisation particulièrement préféré, le composé à base d'hexabenzocoronène de l'invention est le composé de Formule I dans lequel n₁ = 1.
En effet, lorsque n₁ = 0, il s'est avéré que, bien que la résistance à la photo-oxydation de la couche active soit augmentée, l'association des deux matériaux (composé hexabenzocoronène fonctionnalisé par des groupes carboxyliques, cyano, isocyano, cyanate ou CF₃ et polymère ZP46) n'est pas optimale du point de vue des propriétés électroniques et que ce défaut est corrigé par l'inclusion d'une fonction chimique -COO- ou -CONH- qui joue le rôle d'espaceur entre le donneur et l'accepteur sans dénaturation ni des propriétés structurales, ni des propriétés de photorésistance du composé HBC.

Ainsi, un composé de l'invention tout particulièrement préféré est le composé de formule I-1 suivante : 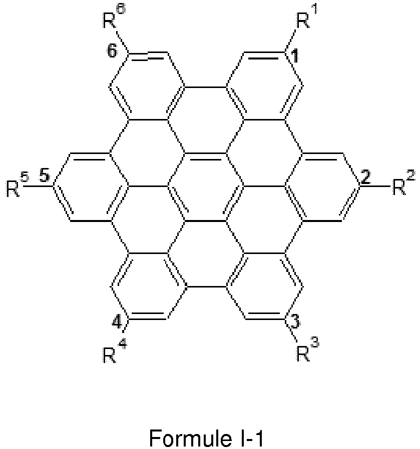 dans laquelle R¹, R³, R⁴ et R⁶ sont des groupes carboxyliques et R² et R⁵ ont la formule -COO-ZP46.

L'invention propose également une couche active comprenant un composé à base d'hexabenzocoronène de l'invention. Elle propose aussi un dispositif comprenant un tel composé ou une telle couche. Plus particulièrement, un tel dispositif est une cellule photovoltaïque.

L'invention sera mieux comprise et d'autres caractéristiques et avantages de celle-ci apparaîtront plus clairement à la lecture de la description qui suit qui est faite en référence aux figures dans lesquelles :
- la Figure 1 montre la structure de bande de la paire donneur:accepteur P3HT:PCBM comparée à celle d'une paire idéale donneur:accepteur,
- la Figure 2 montre la localisation des orbitales moléculaires HOMO et LUMO du composé selon l'invention de l'exemple 1,
- la Figure 3 montre la localisation des orbitales moléculaires HOMO et LUMO du composé de l'invention de l'exemple 2,
- la Figure 4 montre la localisation des orbitales moléculaires HOMO et LUMO du composé selon l'invention de l'exemple 3,
- la Figure 5 montre la localisation des orbitales moléculaires HOMO et LUMO du composé, ne faisant pas partie de l'invention, de l'exemple comparatif 1,
- la Figure 6 montre la localisation des orbitales moléculaires HOMO et LUMO du composé, ne faisant pas partie de l'invention, de l'exemple comparatif 2,
- la Figure 7 montre la localisation des orbitales moléculaires HOMO et LUMO du composé, ne faisant pas partie de l'invention, de l'exemple comparatif 3,
- la Figure 8 montre la localisation des orbitales moléculaires HOMO et LUMO du composé selon l'invention de l'exemple 4,
- la Figure 9 montre la localisation des orbitales moléculaires HOMO et LUMO du composé selon l'invention de l'exemple 5,
- la Figure 10 montre la localisation des orbitales moléculaires HOMO et LUMO du composé selon l'invention de l'exemple 6,
- la Figure 11 montre la localisation des orbitales moléculaires HOMO et LUMO du composé, ne faisant pas partie de l'invention, de l'exemple comparatif 4,
- la Figure 12 montre la localisation des orbitales moléculaires HOMO et LUMO du composé, ne faisant pas partie de l'invention, de l'exemple comparatif 5,
- la Figure 13 montre la localisation des orbitales moléculaires HOMO et LUMO du composé, ne faisant pas partie de l'invention, de l'exemple comparatif 6,
- la Figure 14 montre la localisation des orbitales moléculaires HOMO et LUMO du composé selon l'invention de l'exemple 7,
- la Figure 15 montre la localisation des orbitales moléculaires HOMO et LUMO du composé selon l'invention de l'exemple 8,
- la Figure 16 montre la localisation des orbitales moléculaires HOMO et LUMO du composé selon l'invention de l'exemple 9,
- la Figure 17 montre la localisation des orbitales moléculaires HOMO et LUMO du composé, ne faisant pas partie de l'invention, de l'exemple comparatif 7,
- la Figure 18 montre la localisation des orbitales moléculaires HOMO et LUMO du composé, ne faisant pas partie de l'invention, de l'exemple comparatif 8,
- la Figure 19 montre la localisation des orbitales moléculaires HOMO et LUMO du composé, ne faisant pas partie de l'invention, de l'exemple comparatif 9,
- la Figure 20 montre la localisation des orbitales moléculaires HOMO et LUMO du composé, ne faisant pas partie de l'invention, de l'exemple comparatif 10,
- la Figure 21 montre la localisation des orbitales moléculaires HOMO et LUMO du composé, ne faisant pas partie de l'invention, de l'exemple comparatif 11,
- la Figure 22 montre la localisation des orbitales moléculaires HOMO et LUMO du composé, ne faisant pas partie de l'invention, de l'exemple comparatif 12,
- la Figure 23 montre la localisation des orbitales moléculaires HOMO et LUMO du composé, ne faisant pas partie de l'invention, de l'exemple comparatif 13,
- la Figure 24 montre la localisation des orbitales moléculaires HOMO et LUMO du composé, ne faisant pas partie de l'invention, de l'exemple comparatif 13,
- la Figure 25 montre la localisation des orbitales moléculaires HOMO et LUMO du composé, ne faisant pas partie de l'invention, de l'exemple comparatif 14, et
- la Figure 26 est une représentation schématique de la molécule selon l'invention de l'exemple 9.

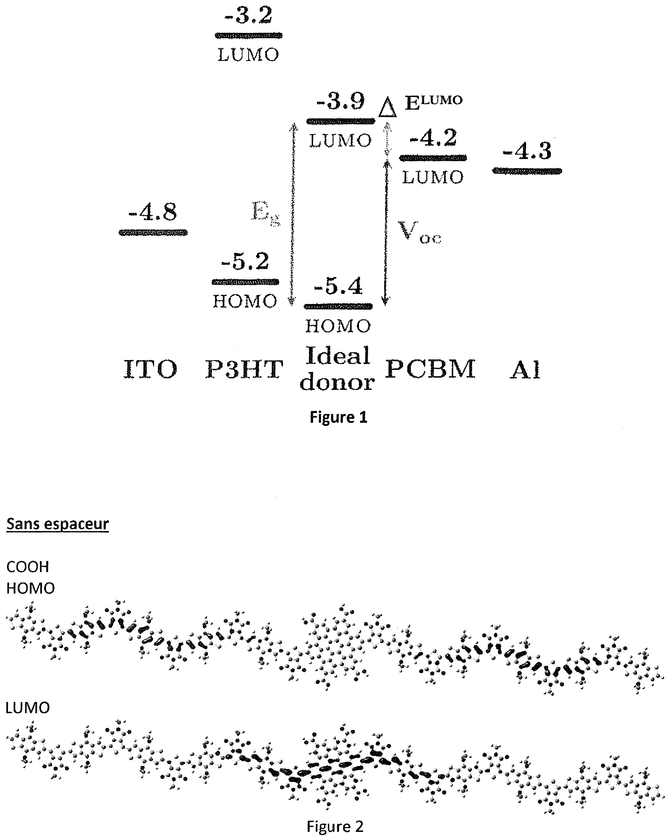

Sur la base de la comparaison entre le gap énergétique HOMO - LUMO de la paire P3HT:PCBM et celui d'une paire donneur:accepteur idéale, schématiquement représentée en Figure 1, les paramètres clés à optimiser pour obtenir un matériau adapté et optimisé pour une efficacité maximale d'une cellule photovoltaïque organique à chaque étape du procédé de conversion de l'énergie solaire en électricité sont brièvement résumées comme étant :
(i) la différence d'énergie entre le LUMO du donneur et le LUMO de l'accepteur (ΔE^{LUMO}), qui doit être de l'ordre de 0.3 eV pour assurer une efficacité idéale pendant le transfert des excitons. Cette valeur est suffisante pour provoquer un transfert d'électron ultra rapide du donneur vers l'accepteur et ne peut pas être réduite en raison de la possibilité de l'inversion du transfert des charges,
(ii) le gap de bande (E_{g}) de la molécule donneur qui doit être proche de 1,5 eV. Pour P3HT, cette valeur est d'environ 1,9 eV et donc trop élevée, limitant ainsi l'absorption de la lumière dans le domaine infrarouge par le polymère,
(iii) la tension de circuit ouvert *Voc* doit être ajustée : si elle est trop élevée, une grande quantité d'énergie est perdue. Si elle est trop faible, l'OPV résultant fonctionnera à une tension faible qui n'est pas nécessaire, rendant la conversion de l'énergie potentielle inefficace, et
(iv) cette paire donneur:accepteur idéale doit résister, en particulier, à la photo-oxydation.

Les inventeurs ont maintenant découvert de nouveaux matériaux à base de graphène, plus précisément des composés à base d'hexabenzocoronènes, qui remplissent la totalité de ces paramètres qui gouvernent l'efficacité du dispositif organique photovoltaïque à la fois des points de vue de la stabilité électronique et de la résistance à l'oxydation.

Plus précisément, les composés de l'invention sont des composés ayant la Formule I suivante : 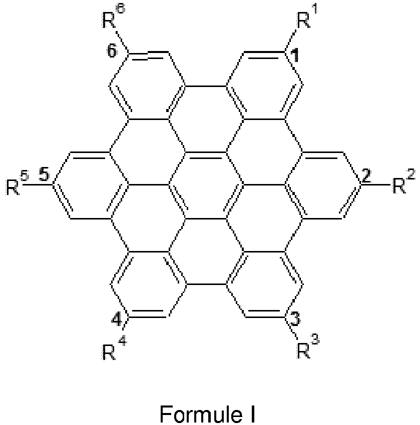 dans laquelle :
- R¹, R³, R⁴ et R⁶ sont choisis indépendamment les uns des autres, parmi un groupe carboxylique (-COOH), un group cyano (-C=N), un groupe isocyano (-N⁺≡C-), un groupe cyanate (-O-C=N) et un group CF₃, et
- R² et R⁵ ont la formule (1) suivante:

   X_{(n₁)}-ZP46 Formule (1)

   dans laquelle :
   ∘ X est un groupe espaceur choisi parmi un groupe -COO- et un groupe -CONH-,
   ∘ n₁ = 0 ou 1, et
   ∘ ZP46 a la formule (2) suivante : 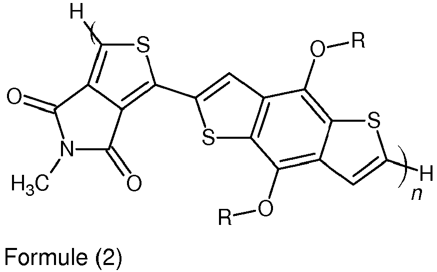
dans laquelle R est methyl ou C6H13.

Ces composés sont supérieurs au PCBM en raison de leur bi-dimensionnalité, ils évitent les micro-agrégations du PCBM résultant en une rupture de la morphologie et une rupture de la couche active et du dispositif.

Ils augmentent les longueurs des trajets des excitons et facilitent le transport des charges.

Cela est dû à la structure colonnaire de ces composés qui fournit un canal pour le flux électronique, et ainsi permet aux charges de diffuser sans perte de charge à l'électrode par une interaction graphène / électrode favorable.

La structure colonnaire est obtenue par le choix de la position et de la nature des substituants R¹, R³, R⁴ et R⁶ dans la Formule I. Un tel choix permet d'obtenir un empilement proche de l'optimal des différentes couches du HBC de l'invention.

Cette structure colonnaire est très stable en raison du choix des substituants R¹, R³, R⁴ et R⁶.

De plus, tous ces substituants R¹, R³, R⁴ et R⁶ permettent d'ajuster les niveaux électroniques du graphène du coeur HBC de sorte que ces niveaux sont dans la phase optimale pour le transfert électronique du système donneur vers le système accepteur.

Parmi les substituants, qui sont choisis parmi un groupe carboxylique, un groupe cyano, un groupe isocyano, un groupe cyanate et un groupe -CF₃, pour R¹, R³, R⁴ et R⁶, un groupe carboxylique est particulièrement préféré car il est plus facile à greffer sur le coeur HBC.

Dans le composé de l'invention, les positions 2 et 5 sont occupées par un polymère conducteur ZP46, de préférence par l'intermédiaire d'un espaceur.

Le polymère ZP46 a la formule (2) suivante : 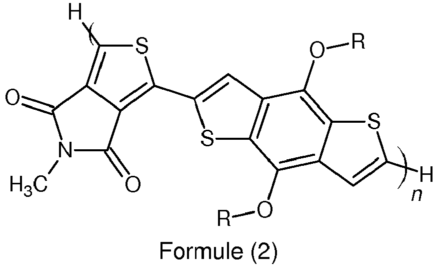 dans laquelle R est methyl ou C6H13.

Ce polymère permet de conférer aux composés de l'invention une stabilité à la fois morphologique et photochimique.

La structure supramoléculaire du polymère ZP46 est déterminée par les interactions non-liantes OH et O S dans les deux co-monomères dont il est constitué, c'est-à-dire le benzo(1,2-b;3,4-b)thiophène et le thiéno[3,4-c]pyrrol-4,6-dione.

Cette structure supramoléculaire peut bloquer les chaînes en une configuration planaire¹ qui peut induire une caractéristique de cristal liquide discotique mimétique avec des chaînes adjacentes basées sur les mêmes interactions.
**¹** Nicolas E. Jackson et al. « Controlling conformation of conjugated polymers and molécules, the wall of non-binding interaction », Journal of the American Chemical Society, 135, 28:10475-10483, 2013

Pour qu'une paire donneur:accepteur ait une efficacité pour une application dans une cellule photovoltaïque, il faut d'abord que cette paire donneur:accepteur permette d'obtenir une bonne localisation des électrons à l'état de base (orbitale moléculaire HOMO) dans la partie donneur (dans les composés de Formule II dans les polymères ZP46) et de transférer ces électrons de manière localisée dans la partie accepteur lors d'une émission de lumière (orbitale moléculaire LUMO) des composés de l'invention, c'est-à-dire dans la partie hexabenzocoronène (dans le composé de Formule I).

Il faut ensuite que cette molécule donneur:accepteur puisse former un empilement colonnaire et hélicoïdal.

Enfin il faut que cette molécule donneur:accepteur permette une bonne séparation entre les niveaux énergétiques des orbitales HOMO et LUMO.

Les composés de l'invention, ont ces propriétés, comme cela va être démontré dans les exemples et exemples comparatifs qui suivent.

### Exemple 1

On a synthétisé un composé selon l'invention de Formule I-1 dans laquelle n = 0, c'est-à-dire que les polymères ZP46 sont liés aux positions 2 et 6 du coeur hexabenzocoronène directement, et dans laquelle les substituants R¹, R³, R⁴ et R⁶ sont un groupe carboxylique (-COOH).

La Figure 2 montre la localisation des orbitales HOMO et LUMO de ce composé.

Comme on peut le voir, en Figure 2, l'orbitale LUMO dans ce composé de l'invention n'est pas localisée seulement sur le coeur HBC (la localisation des électrons est montrée par une partie plus sombre) mais se délocalise vers le polymère ZP46 lui-même, gênant la dissociation des charges et leur transfert dans la direction de l'empilement π, mais en permettant cependant une telle dissociation et un tel transfert. Autrement dit, ce composé peut être utilisé dans des applications dans lesquelles une efficacité parfaite n'est pas nécessaire mais dans lesquelles la résistance à la photo oxydation est importante.

### Exemple 2

On a synthétisé un composé selon l'invention de formule I dans laquelle n = 0 (pas d'espaceur entre le polymère ZP46 et le coeur hexabenzocoronène) et les substituants R¹, R³, R⁴ et R⁶ sont des groupements cyano (-C=N).

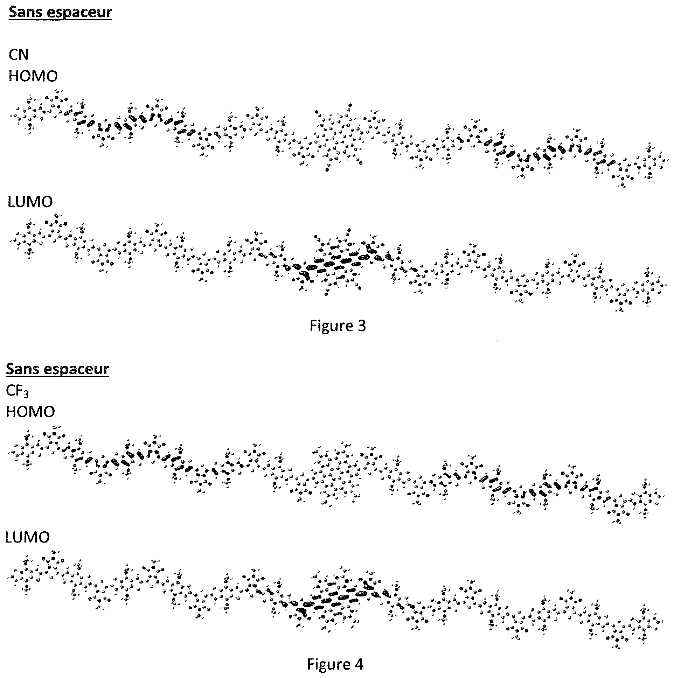

La Figure 3 montre la localisation des électrons dans les orbitales HOMO et LUMO de ce composé.

Comme on peut le voir en Figure 3, l'orbitale LUMO dans le composé de l'invention n'est pas localisée seulement sur le coeur HBC mais se délocalise vers le polymère ZP46 lui-même, gênant la dissociation des charges et leur transfert dans la direction de l'empilement π, mais en permettant cependant une telle dissociation et un tel transfert. Autrement dit, ce composé peut être utilisé dans des applications dans lesquelles une efficacité parfaite n'est pas nécessaire mais dans lesquelles la résistance à la photo oxydation est importante.

### Exemple 3

On a synthétisé un composé selon l'invention de formule I dans laquelle n = 0 (les polymères ZP46 sont directement liés aux positions 2 et 5 du coeur hexabenzocoronène, sans espaceur) et dans laquelle les substituants R¹, R³, R⁴ et R⁶ sont des groupements CF₃.

La Figure 4 représente la localisation des électrons dans les orbitales HOMO et LUMO de ce composé.

Comme on peut le voir en Figure 4, l'orbitale LUMO dans ce composé n'est pas localisée seulement sur le coeur HBC mais se délocalise vers le polymère ZP46, mais en permettant cependant une telle dissociation et un tel transfert. Autrement dit, ce composé peut être utilisé dans des applications dans lesquelles une efficacité parfaite n'est pas nécessaire mais dans lesquelles la résistance à la photo oxydation est importante.

On peut également voir à partir des figures 2 à 4 que l'orbitale HOMO est localisée sur le polymère ZP46 de manière très distincte du coeur HBC et que même si l'orbitale LUMO dans ces composés n'est pas localisée parfaitement sur le coeur HBC elle reste cependant très localisée sur ce dernier.

Sans vouloir être liés par la théorie, les inventeurs pensent que le fait que l'orbitale LUMO dans ces composés ne soit pas localisée seulement sur le coeur HBC peut être dû aux propriétés de l'accepteur du co-monomère de ZP46 qui est directement lié au coeur HBC et qui peut entrer en compétition pendant la délocalisation du nuage électronique du niveau LUMO (caractère électronique pauvre à l'état de base). Cependant le greffage du copolymère ZP46 dans l'autre sens, c'est-à-dire en liant directement la moitié donneur d'abord, n'est pas souhaitable en raison du manque d'interaction non-liante entre le segment et le coeur HBC par des liaisons hydrogène.

Cependant, la stabilité conformationnelle ainsi que la résistance à la photo-oxydation de ces composés est fortement augmentée. Le même phénomène a été obtenu lorsque les substituants R¹, R³, R⁴ et R⁶ du coeur HBC étaient modifiés pour être non pas des groupements carboxyliques mais des groupements cyano, ou isocyano, ou cyanate ou F.

Dès lors, le composé de l'invention dans lequel le polymère ZP46 est directement lié au coeur HBC présente un intérêt fort en tant que paire donneur:accepteur grâce à sa remarquable résistance à la photo-oxydation comparé à une molécule idéale.

Le choix des substituants R¹, R³, R⁴ et R⁶ est très important pour obtenir une séparation de charges efficace lors de l'excitation par la lumière.

Pour cela, des composés de Formule I dans lesquels n = 0 mais dans lesquelles les substituants R¹, R³, R⁴ et R⁶ sont respectivement un atome de F, un groupe -NH₂, un groupe -NO₂ ont été synthétisés et font l'objet des exemples comparatifs 1 à 3 qui suivent, et ils démontrent que ces choix sont très importants.

### Exemple comparatif 1

On a synthétisé un composé de Formule I dans laquelle n = 0, c'est-à-dire un composé dans lequel les polymères ZP46 sont liés directement aux positions 2 et 5 du coeur hexabenzocoronène, et dans laquelle les substituants R¹, R³, R⁴ et R⁶ sont un atome de F.

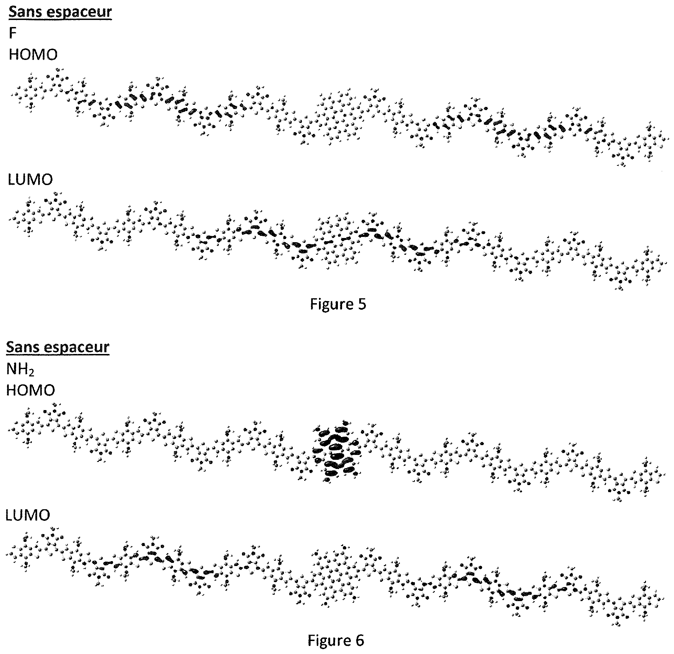

La localisation des orbitales moléculaires HOMO et LUMO de ce composé est montrée en Figure 5.

Comme on peut le voir en Figure 5, l'orbitale LUMO n'est pas du tout localisée sur le coeur HBC dans cette molécule.

Ce composé ne peut donc être utilisé en tant que paire donneur: accepteur dans une couche active.

### Exemple comparatif 2

On a synthétisé un composé de Formule I dans laquelle n = 0, et R¹, R³, R⁴ et R⁶ sont des groupes -NH₂.

La Figure 6 montre la localisation des orbitales moléculaires HOMO et LUMO dans ce composé.

Comme on le voit en Figure 6, l'orbitale LUMO n'est pas du tout localisée sur le coeur HBC mais totalement délocalisée vers le polymère ZP46. On obtient même l'inverse de ce que l'on cherche : il faut que les électrons aillent du donneur vers l'accepteur en passant de la HOMO vers la LUMO.

Une telle molécule ne peut être utilisée en tant que paire donneur: accepteur dans une couche active.

### Exemple comparatif 3

On a synthétisé un composé de Formule I dans laquelle n = 0, et les substituants R¹, R³, R⁴ et R⁶ sont des groupes -NO₂.

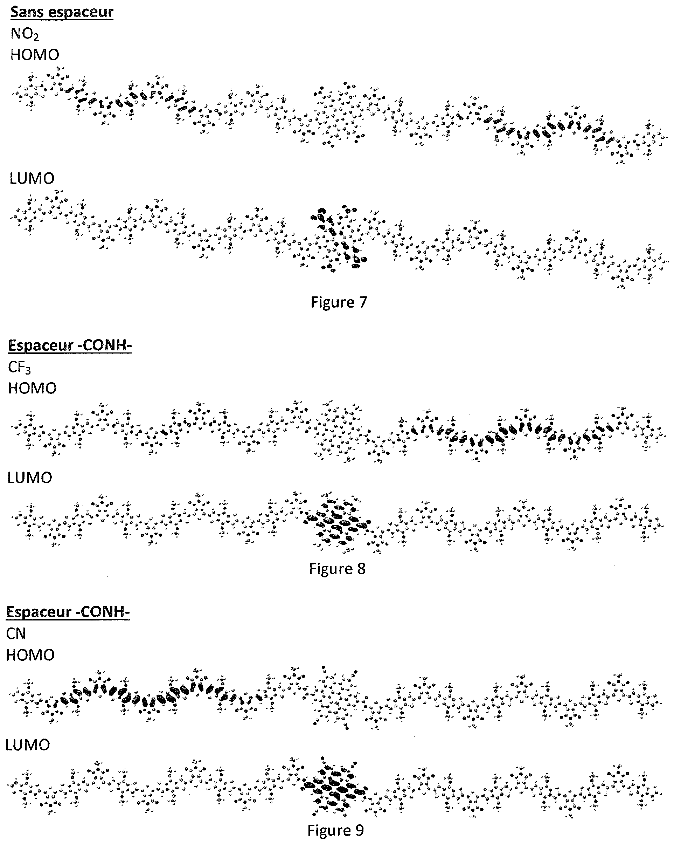

La Figure 7 montre la localisation des orbitales HOMO et LUMO dans ce composé.

Comme on le voit en Figure 7, l'orbitale LUMO n'est pratiquement pas localisée sur le coeur HBC mais se concentre sur les substituants R¹, R³, R⁴ et R⁵, très électro attracteurs : ces derniers ne relâcheront jamais les électrons pour créer le courant désiré. En effet, il n'y a aucune autre fonction chimique qui soit plus à la recherche pour piéger des électrons. Jamais NO₂ ne relâchera ces derniers s'il a réussi à les capter.

Ce composé ne peut pas être utilisé en tant que paire donneur: accepteur d'une couche active.

Pour pallier le problème de la faible localisation des composés de l'invention de Formule I dans lesquels les polymères ZP46 sont liés directement au coeur HBC, les inventeurs ont découvert, que lorsque l'on utilise un groupe espaceur entre le coeur HBC et le polymère ZP46, le problème de la perte d'efficacité de la séparation des charges était surmonté, lorsque cet espaceur était un groupe amide (-CONH-) ou un groupe ester (-COO-).

En effet, le choix de la présence et de la nature de cet espaceur permet de retrouver une bonne séparation des charges lors d'une excitation par la lumière spatialement efficace, comme cela va être montré dans les exemples qui suivent.

### Exemple 4

On a synthétisé un composé de Formule I dans laquelle n = 1, X (espaceur) est -CONH- et les substituants R¹, R³, R⁴ et R⁶ sont des groupes CF₃.

La Figure 8 montre la localisation des orbitales moléculaires HOMO et LUMO dans ce composé.

Comme on le voit en Figure 8, l'orbitale LUMO est localisée sur le coeur HBC et l'orbitale HOMO est localisée sur le polymère ZP46.

Ce composé est donc parfaitement adapté pour former la paire donneur:accepteur d'une couche active.

### Exemple 5

On a synthétisé un composé de Formule I dans laquelle n = 1, X (espaceur) est -CONH- et les substituants R¹, R³, R⁴ et R⁶ sont des groupes cyano (CN).

La Figure 9 montre la localisation des orbitales HOMO et LUMO dans ce composé.

Comme on le voit, l'orbitale LUMO est parfaitement localisée sur le coeur HBC.

Ce composé est donc adapté pour former la paire donneur:accepteur d'une couche active.

### Exemple 6

On a synthétisé un composé de Formule I dans laquelle n = 1, X (espaceur) est -CONH- et les substituants R¹, R³, R⁴ et R⁶ sont des groupes -COOH.

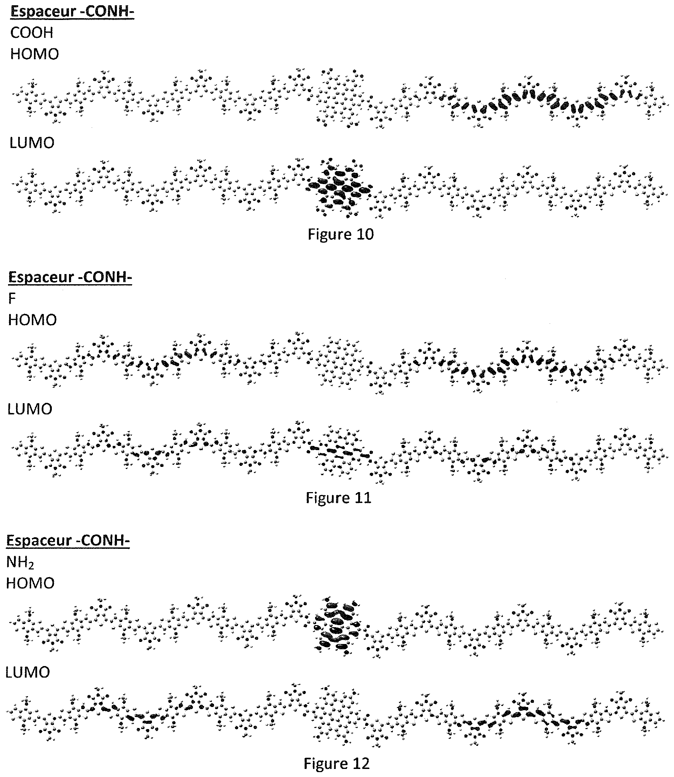

La Figure 10 montre la localisation des orbitales HOMO et LUMO de ce composé.

Comme on peut le voir, l'orbitale LUMO est parfaitement localisée sur le coeur HBC.

Ce composé est donc parfaitement adapté pour constituer la paire donneur:accepteur d'une couche active.

### Exemples comparatifs 4 à 6

Aux exemples comparatifs 4 à 6, on a synthétisé des composés de Formule I dans lesquels n = 1, X (espaceur) est -CONH- et lesquels, respectivement, les substituants R¹, R³, R⁴ et R⁵ sont tous soit un atome de F, soit un groupe -NH₂, soit un groupe -NO₂, pour montrer l'importance du choix de ces substituants.

Les Figures 11 à 13 montrent la localisation des orbitales HOMO et LUMO dans chacun de ces composés respectivement.

Comme on le voit en Figure 11, lorsque les substituants R¹, R³, R⁴ et R⁵ sont des atomes de F, l'orbitale LUMO est délocalisée sur l'ensemble de la molécule. Cette molécule ne peut constituer la paire donneur:accepteur d'une couche active.

Comme on le voit en Figure 12, le composé de Formule I dans lequel le substituant R¹, R³, R⁴ et R⁶ est un groupe -NH₂, ne peut pas non plus constituer la paire donneur:accepteur d'une couche active : l'orbitale LUMO est totalement délocalisée sur les polymères ZP46.

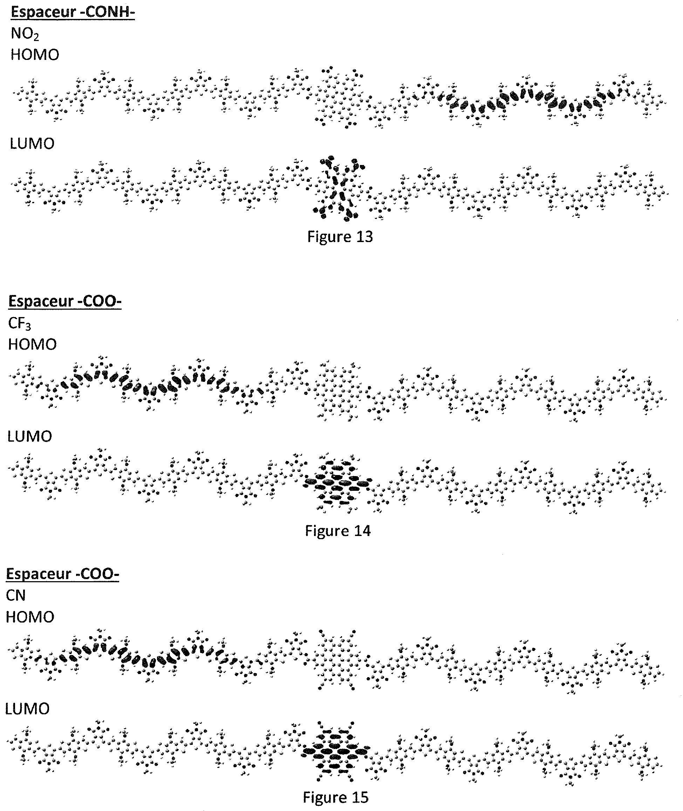

Le composé de l'exemple comparatif 6 dans lequel les substituants R¹, R³, R⁴ et R⁶ sont des groupes -NO₂ ne peut pas non plus constituer une paire donneur:accepteur d'une couche active, comme on peut le voir en Figure 13 : l'orbitale LUMO est délocalisée sur ces substituants et non pas localisée sur le coeur HBC.

### Exemples 7 à 9

Ces exemples ont pour but de montrer que lorsque l'espaceur est un groupe -COO-, le composé de formule I selon l'invention, constitue une excellent paire donneur:accepteur d'une couche active.

On a synthétisé à l'exemple 7 un composé de Formule I dans laquelle les substituants R¹, R³, R⁴ et R⁶ sont des groupes -CF₃, à l'exemple 8, les substituants R¹, R³, R⁴ et R⁶ sont des groupes -CN et à l'exemple 9, les substituants R¹, R³, R⁴ et R⁶ sont des groupes -COOH.

La localisation des orbitales moléculaires HOMO et LUMO de chacun de ces composés sont montrées respectivement aux Figures 14, 15 et 16.

Comme on peut le voir sur ces figures, l'orbitale LUMO est parfaitement localisée sur le coeur HBC dans ces composés.

### Exemples comparatifs 7 à 9

Pour montrer l'importance de la nature des substituants R¹, R³, R⁴ et R⁵, dans les composés de Formule I dans lesquels l'espaceur est un groupe -COO, on a synthétisé dans l'exemple comparatif 7 un composé de Formule I dans lequel les substituants R¹, R³, R⁴ et R⁶ sont des atomes de F, à l'exemple comparatif 8 un composé dans lequel les substituants R¹, R³, R⁴ et R⁶ sont un groupe-NH₂ et à l'exemple comparatif 9 un composé de Formule 1 dans lequel les substituants R¹, R³, R⁴ et R⁶ sont un groupe -NO₂.

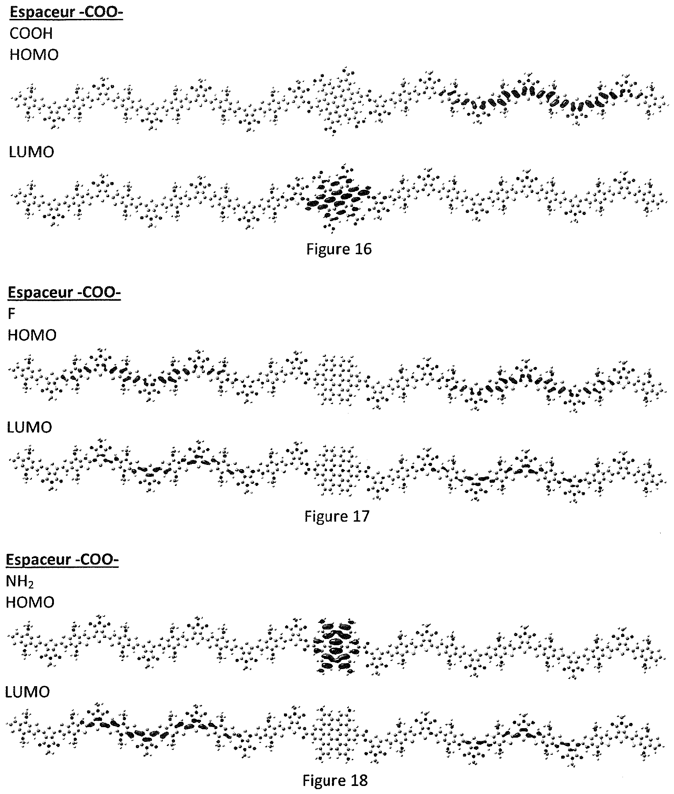

La localisation des orbitales moléculaires HOMO et LUMO de ces composés est montrée respectivement aux Figures 17 à 19.

Comme on peut le voir aux Figures 17 et 18, les orbitales LUMO des composés obtenus aux exemples comparatifs 7 et 8 sont totalement délocalisées sur les polymères ZP46 et dans le composé de l'exemple comparatif 9, l'orbitale LUMO est délocalisée sur les substituants électro attracteurs -NO₂.

Ces composés ne peuvent donc pas former la paire donneur:accepteur d'une couche active.

### Exemples comparatifs 10 à 15

Ces exemples montrent que la nature des espaceurs est également très importante.

On a synthétisé des composés de Formule I dans lesquels n = 1 et X, l'espaceur, est -C = C-.

A l'exemple comparatif 10, les substituants R¹, R³, R⁴ et R⁶ sont un groupe -CF₃, à l'exemple comparatif 11, les substituants R¹, R³, R⁴ et R⁶ sont un groupe -C=N, à l'exemple comparatif 12, les substituants R¹, R³, R⁴ et R⁶ sont un groupe -COOH et, à l'exemple comparatif 13 les substituants R¹, R³, R⁴ et R⁶ sont un atome de F, à l'exemple comparatif 14 les substituants R¹, R³, R⁴ et R⁶ sont un groupe -NH₂, et à l'exemple comparatif 15, les substituants R¹, R³, R⁴ et R⁶ sont des groupes -NO₂

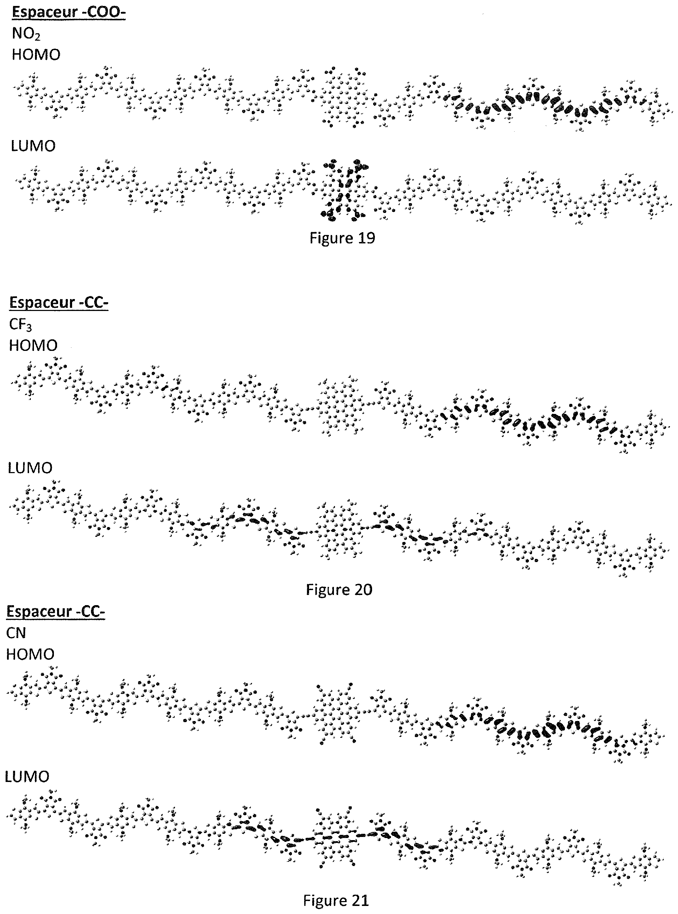

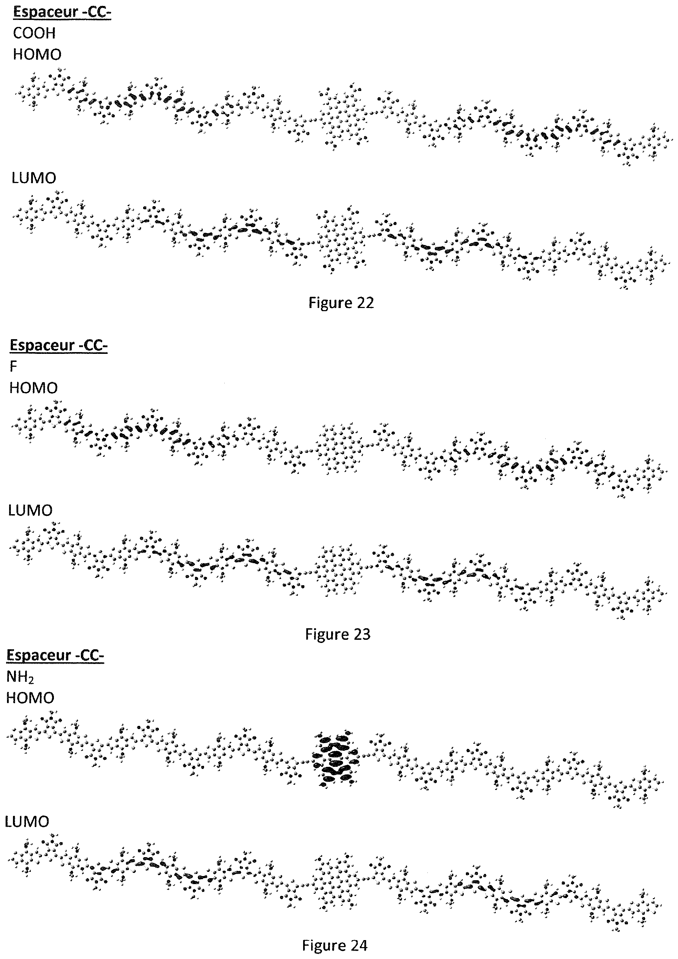

Les Figures 20 à 25 montrent respectivement la localisation des orbitales HOMO et LUMO de ces composés.

Comme on peut le voir aux Figures 20 à 24, les composés des exemples comparatifs 10 à 14 ne peuvent pas former une paire donneur:accepteur d'une couche active : l'orbitale LUMO est délocalisée sur les polymères ZP46.

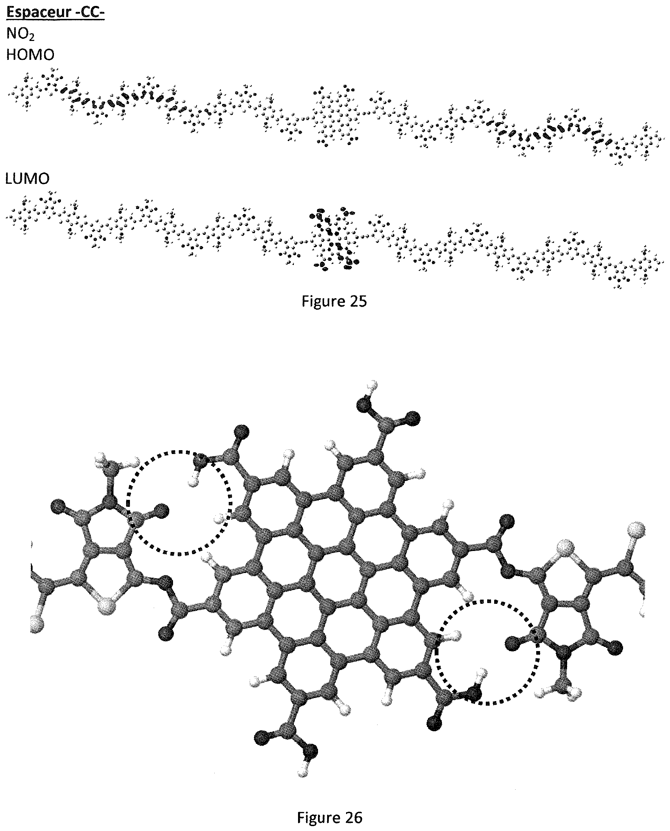

Comme on peut le voir en Figure 25, le composé de l'exemple comparatif 15 ne peut pas non plus servir de paire donneur:accepteur pour une couche active : l'orbitale LUMO est délocalisée sur les substituants R¹, R³, R⁴ et R⁶, c'est-à-dire sur les groupes -NO₂.

Comme on peut le voir aux Figures 8 à 10, l'utilisation d'une fonction amide (-CONH-) en tant qu'espaceur dans le composé de l'invention permet de séparer efficacement les charges lors d'une excitation par la lumière : il n'y a pas de chevauchement entre le niveau de base et les états excités des orbitales frontières, ce qui indique une séparation des charges efficace.

Comme on peut le voir en Figure 7 à 9, le même effet est constaté lorsqu'un espaceur ester (-COO-) est utilisé, et, de plus, l'insertion de ce groupe en tant qu'espaceur est d'un intérêt particulier car il peut former des liaisons hydrogène bloquant la planéité entre le polymère conjugué ZP46 et le coeur HBC, comme le montre la Figure 26.

La Figure 26 est une représentation schématique du composé de l'exemple 9, c'est-à-dire d'un composé de Formule I dans laquelle n = 1, X (espaceur) est -COO- et les substituants R¹, R³, R⁴ et R⁶ sont des groupes -COOH.

Comme on le voit en Figure 26, le composé de l'exemple 9 a une planéité bloquée entre le coeur HBC et le polymère ZP46 notamment par des interactions non liantes de type liaisons hydrogène qui sont représentées en Figure 26 par les cercles en pointillés. Ces interactions sont des interactions entre les groups C=O du polymère ZP46 et les substituants R³ et R⁶.

Les composés de Formule I dans lesquels l'espaceur est un groupe ester présente de plus un autre intérêt : ils sont faciles à synthétiser, en particulier lorsque les substituants R¹, R³, R⁴ et R⁶ sont des groupes carboxylique.

Les composés de l'invention ayant une bonne planéité peuvent former des empilements colonnaires et hélicoïdaux.

Les deux premières conditions, à savoir la localisation des charges et en particulier des orbitales moléculaires LUMO et HOMO, et la capacité à créer une structure colonnaire et hélicoïdale stable sont donc remplies par les composés de l'invention.

Pour montrer que les composés de l'invention n'introduisent pas de perte d'efficacité et conservent la séparation énergétique entre les orbitales moléculaires HOMO et LUMO, leurs niveaux d'énergie HOMO et LUMO ont été mesurés.

Ces valeurs de niveaux d'énergie HOMO et LUMO sont reportées au Tableau 1 suivant.

**Tableau 1**

| R²et R⁵ = ZP46 | **Sans espaceur** | | **Espaceur -CC-** | | **Espaceur -CONH-** | | **Espaceur -COO-** | |
|---|---|---|---|---|---|---|---|---|
| R¹, R³, R⁴ et R⁶ = | **HOMO (eV)** | **LUMO (eV)** | **HOMO (eV)** | **LUMO (eV)** | **HOMO (eV)** | **LUMO (eV)** | **HOMO (eV)** | **LU MO (eV)** |
| -CF₃ | -7,39 | -1,89 | -7,39 | -1,83 | -7,38 | -1,95 | -7,39 | -1,94 |
| -CN | -7,40 | -1,93 | -7,40 | -1,86 | -7,39 | -1,99 | -7,39 | -1,98 |
| -COOH | -7,39 | -1,85 | -7,39 | -1,82 | -7,40 | -2,09 | -7,40 | -1,88 |
| -F | -7,39 | -1,83 | -7,39 | -1,82 | -7,38 | -1,80 | -7,39 | -1,80 |
| -NH₂ | -6,75 | -1,80 | -6,77 | -1,81 | -6,97 | -1,79 | -6,90 | -1,80 |
| -NO₂ | -7,40 | -3,10 | -7,40 | -3,15 | -7,39 | -3,29 | -7,39 | -3,22 |
| R¹, R³, R⁴ et R⁶ = H | | | | | | | | |
| R²et R⁵ = | | | | | | | | |
| **ZP46** | -7,40 | -1,82 | | | | | | |
| R¹, R³, R⁴ et R⁶ =COOH | | | | | | | | |
| R²et R⁵ = H | | | | | | | | |
| **HBC(COOH)₄** | -7,73 | -1,66 | | | | | | |
| R¹, R³, R⁴ et R⁶ =COOH | | | | | | | | |
| R²et R⁵ = (P3OPT)₁₀ | | | | | | | | |
| **HBC(COOH)₄ -P3AOT₁₀** | -6,31 | -1,16 | | | | | | |
| R¹, R³, R⁴ et R⁶ = H | | | | | | | | |
| R²et R⁵ = (P3OPT)₁₀ | | | | | | | | |
| **P3AOT₁₀** | -6,39 | -1,15 | | | | | | |

Comme on peut le voir à partir du tableau 1, les composés de l'invention n'introduisent pas de perte d'efficacité et conservent la séparation énergétique entre les orbitales moléculaires HOMO et LUMO.

Dans un mode de réalisation particulièrement préféré de l'invention, le composé à base d'hexabenzocoronène de Formule I est un composé dans lequel le polymère ZP46 est lié au coeur HBC par un espaceur qui est soit -CONH- soit -COOX- et plus particulièrement dans lequel l'espaceur est -COO-.

Une couche active comprenant un composé de Formule I selon l'invention présente donc des caractéristiques de stabilité à la photooxydation et des propriétés électroniques particulièrement avantageuses.

De la même façon, un dispositif électronique comprenant un tel composé possède une stabilité conformationnelle et une résistance à la photooxydation particulièrement avantageuses.

Un tel dispositif électronique est en particulier une cellule photovoltaïque organique.

Les composés de l'invention ont été synthétisés selon le schéma réactionnel suivant dans lequel, à l'étape e) mW signifie un chauffage par microondes et DDQ désigne la 2,3-dichloro-5,6-1,4-benzoquinone.

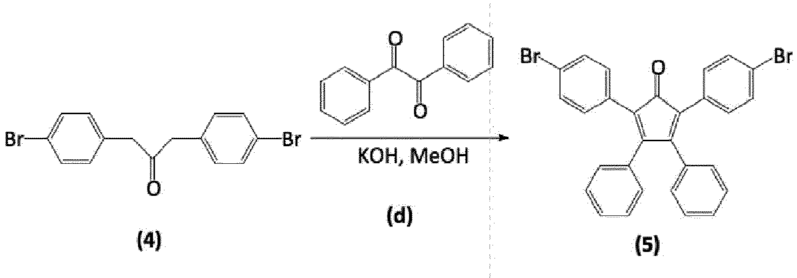

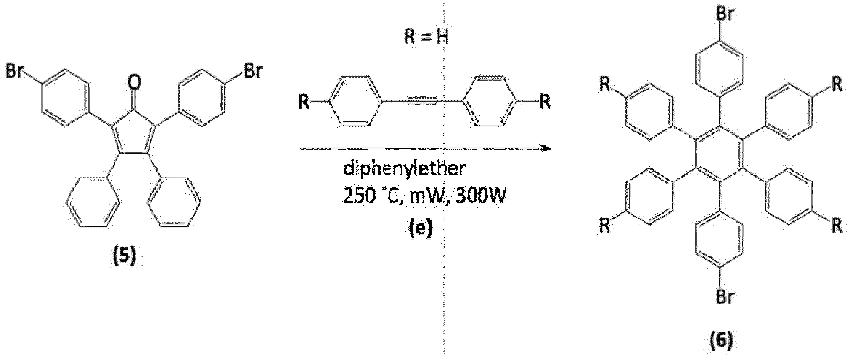

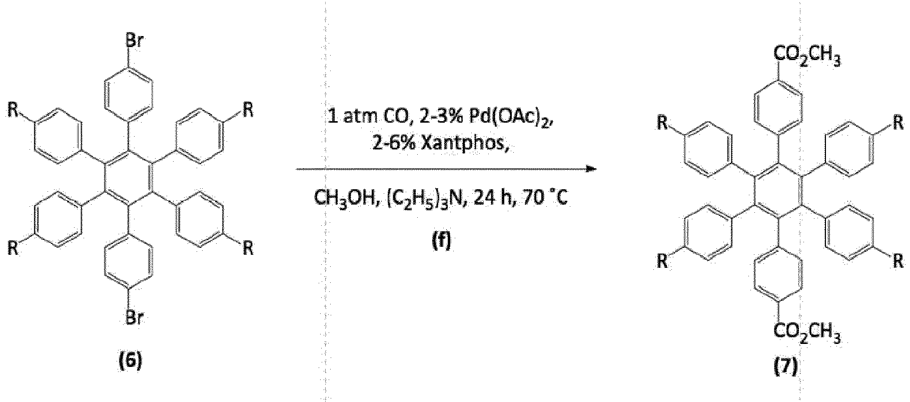

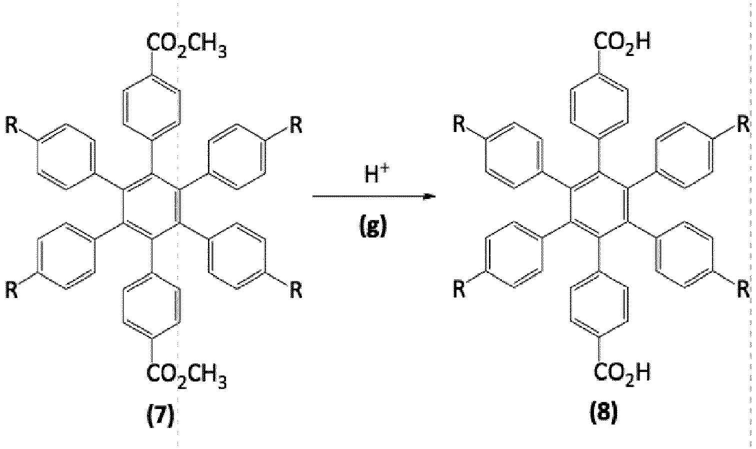

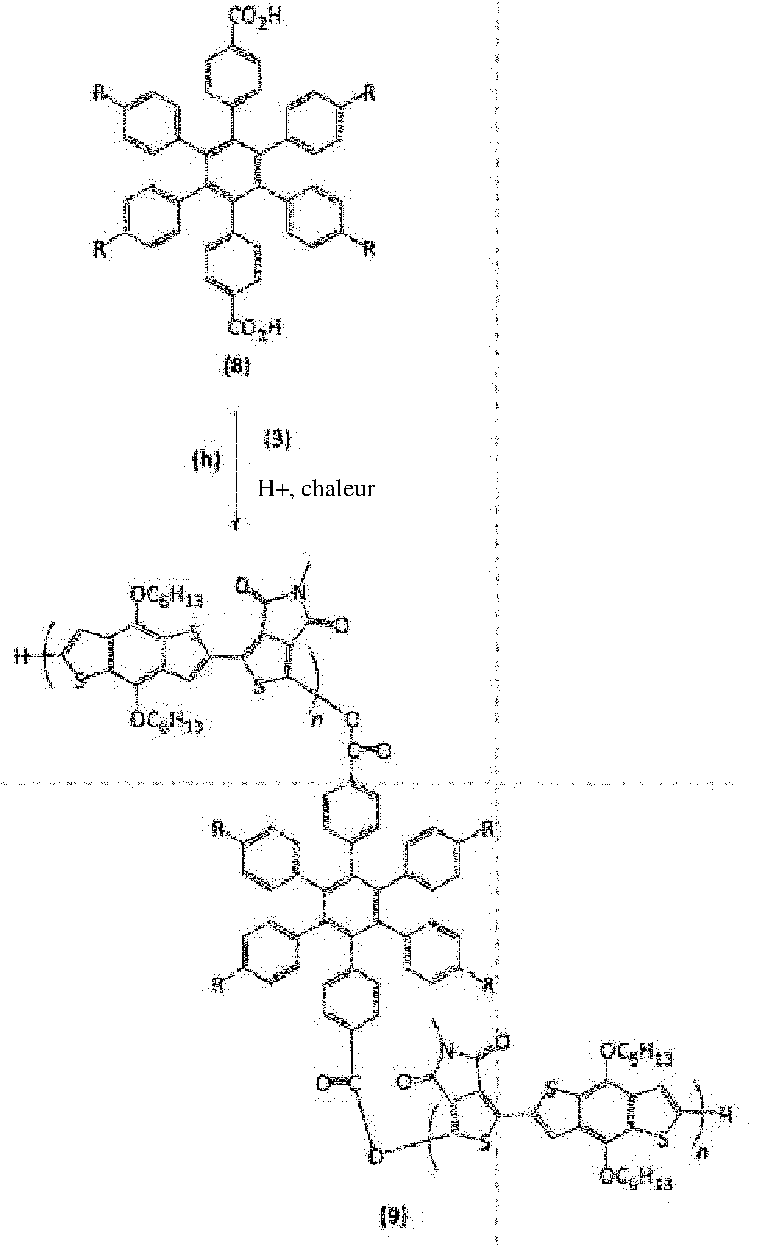

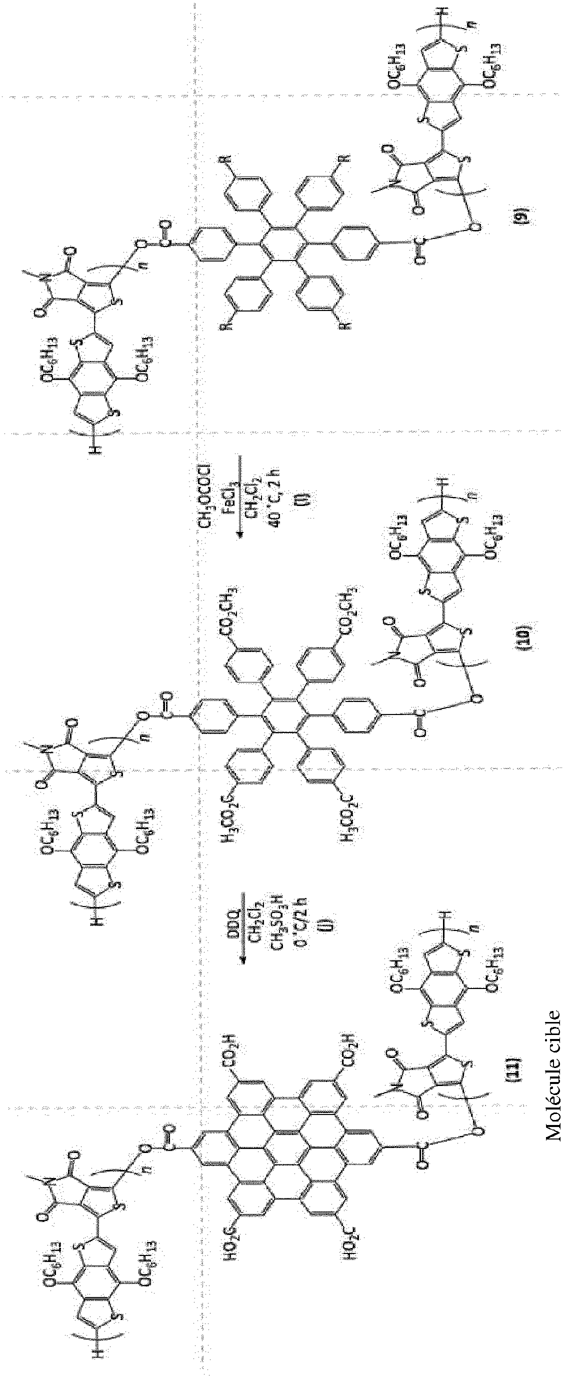

Ce schéma réactionnel montre plus précisément la synthèse du composé préféré de l'invention dans lequel l'espaceur est un groupe -COO-.

L'étape f) a été menée comme décrit dans J. R. Martinelli, D. A. Watson, D. M. M. Freckmann, T. E. Barder, et S. L. Buchwald, J. Org. Chem. 2008, 73, 7102-7107 et C. Wai Cheung and S. L. Buchwald, Organic Letters, 2013, 15, 3998-4001.

Le composé ZP46 utilisé pour synthétisé les composés de l'invention a été synthétisé selon le schéma réactionnel suivant :

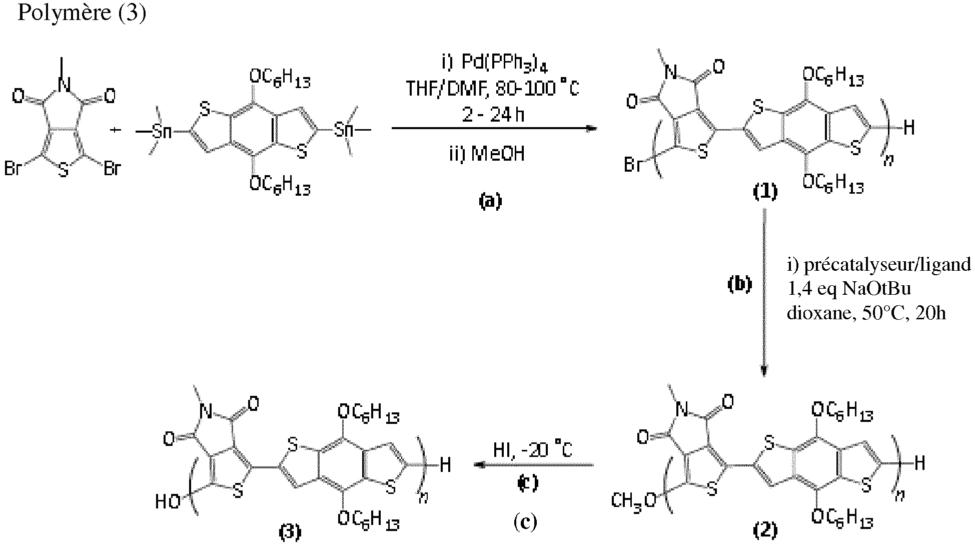

Le précatalyseur utilisé à l'étape b) était un précatalyseur Palladacycle décrit dans C. Wai Cheung and S. L. Buchwald, Organic Letters, 2013, 15, 3998-4001.

## Revendications

1. Composé à base d'hexabenzocoronène ayant la formule I suivante : 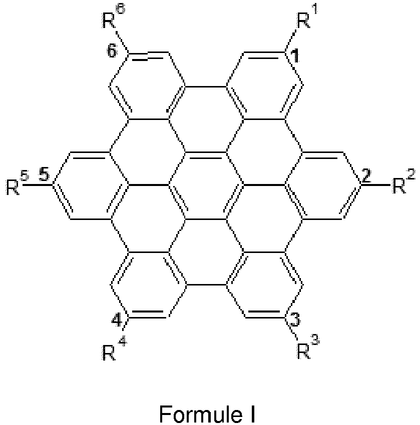 dans laquelle :
- R¹, R³, R⁴ et R⁶ sont choisis, indépendamment les uns des autres, parmi un groupe carboxylique (-COOH), un groupe cyano (-C=N), un groupe isocyano (-N⁺≡C-), un groupe cyanate (-O-C=N) et un groupe (CF₃), et
- R²et R⁵ ont la formule (1) suivante:
X_{(n₁)}-ZP46
Formule (1 ) dans laquelle :
∘ X est un groupe espaceur choisi parmi un groupe -COO- et un groupe -CONH-,
∘ n₁=0 ou 1, et
∘ ZP46 a la formule (2) suivante : 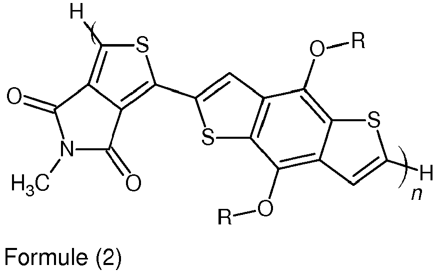
dans laquelle R est methyl ou C6H13.

2. Composé à base d'hexabenzocoronène selon la revendication 1, dans lequel R¹, R³, R⁴ and R⁶ sont identiques et sont des groupes carboxyliques.

3. Composé à base d'hexabenzocoronène selon la revendication 1 ou 2, dans lequel dans la Formule I, n₁ = 1 et X est un groupe -COO -.

4. Composé selon l'une quelconque des revendications 1 à 3, dans lequel R est méthyl.

5. Composé selon l'une quelconque des revendications 1 à 3, dans lequel R est C6H13.

6. Composé selon l'une quelconque des revendications 1 à 5 de formule I-1 suivante : 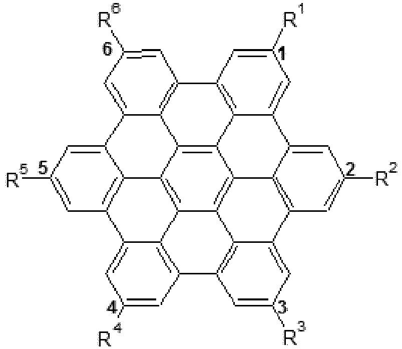 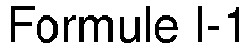 dans laquelle R¹, R³, R⁴ et R⁶ sont des groupes carboxyliques et R² et R⁵ ont la formule -COO-ZP46, dans laquelle ZP46 a la formule (2) suivante : 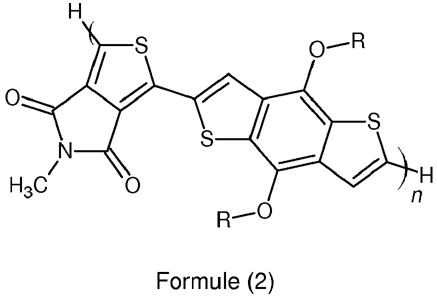 dans laquelle R est methyl ou C6H13.

7. Couche donneur : accepteur comprenant un empilement de composés à base d'hexabenzocoronène selon l'une quelconque des revendications 1 à 6.

8. Dispositif comprenant au moins un composé à base d'hexabenzocoronène selon l'une quelconque des revendications 1 à 6.

9. Dispositif selon la revendication 8 qui est une cellule photovoltaïque.

## Patentansprüche

1. Verbindung auf Hexabenzocoronen-Basis, das die folgende Formel I aufweist: 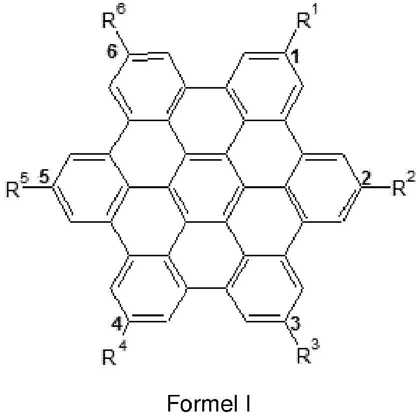 wobei:
- R¹, R³, R⁴ und R⁶ unabhängig voneinander ausgewählt sind aus einer Carboxylgruppe (-COOH), einer Cyanogruppe (-C=N), einer Isocyanogruppe (-N⁺≡C-), einer Cyanatgruppe (-O-C=N) und einer Gruppe (CF₃), und
- R² und R⁵ die folgende Formel (1) aufweisen:
X₍ₙ₁₎-ZP46
Formel (1), wobei:
o X eine Spacer-Gruppe ist, ausgewählt aus einer Gruppe -COO- und einer Gruppe -CONH-
o n₁₌ 0 oder 1, und
o ZP46 die folgende Formel (2) aufweist: 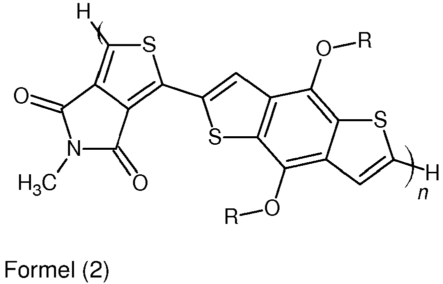
wobei R Methyl oder C6H13 ist.

2. Verbindung auf Hexabenzocoronen-Basis nach Anspruch 1, wobei R¹, R³, R⁴ und R⁶ gleich sind und Carboxylgruppen sind.

3. Verbindung auf Hexabenzocoronen-Basis nach Anspruch 1 oder 2, wobei in Formel I n₁ = 1 und X eine Gruppe -COO- ist.

4. Verbindung nach einem der Ansprüche 1 bis 3, wobei das R Methyl ist.

5. Verbindung nach einem der Ansprüche 1 bis 3, wobei das R C6H13 ist.

6. Verbindung nach einem der Ansprüche 1 bis 5 der folgenden Formel I-1: 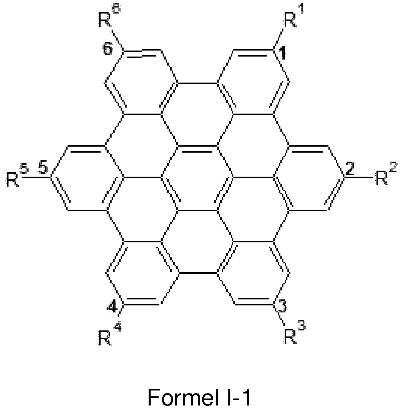 wobei R¹, R³, R⁴ und R⁶ Carboxylgruppen sind und R² und R⁵ die Formel -COO-ZP46 aufweisen, wobei ZP46 die folgende Formel (2) aufweist: 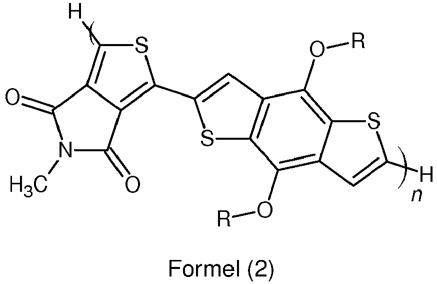 wobei R Methyl oder C6H13 ist.

7. Donor -Schicht: Akzeptor, umfassend einen Stapel von Verbindungen auf Hexabenzocoronen-Basis nach einem der Ansprüche 1 bis 6.

8. Vorrichtung, umfassend mindestens eine Verbindung auf Hexabenzocoronen-Basis nach einem der Ansprüche 1 bis 6

9. Vorrichtung nach Anspruch 8, die eine photovoltaische Zelle ist.

## Claims

1. Compound based on hexabenzocoronene having the following formula I: 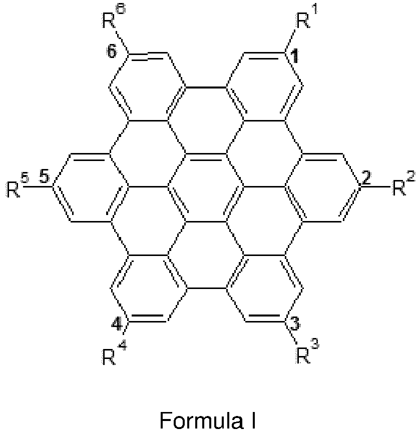 in which :
- R¹, R³, R⁴ and R⁶ are chosen, independently of each other, from a carboxylic group (-COOH), a cyano group (-C=N), an isocyanate group; (-N+≡C-), a cyanate group (-O-C=N) and a group (CF₃), and
- R² and R⁵ have the following formula (1):
X₍ₙ₁₎-ZP46
Formula (1) in which:
∘ X is a spacer group selected from a group -COO- and a group -CONH-,
∘ n₁ = 0 or 1, and
∘ ZP46 has the following formula (2): 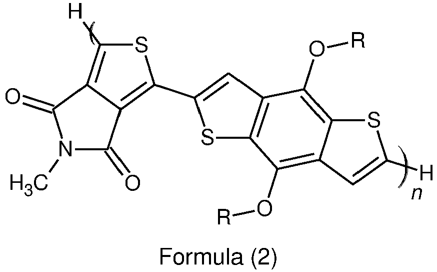
in which R is methyl or C6H13.

2. Compound based on hexabenzocoronene according to claim 1, wherein R¹, R³, R⁴ and R⁶ are the same and are carboxylic groups.

3. Compound based on hexabenzocoronene according to claim 1 or 2, wherein in Formula I, n1 = 1 and X is a -COO- group.

4. Compound according to any one of the claims 1 to 3, wherein R is methyl.

5. Compound according to any one of the claims 1 to 3, wherein R is C6H13.

6. Compound according to any one of the claims 1 to 5 of formula I-1 below: 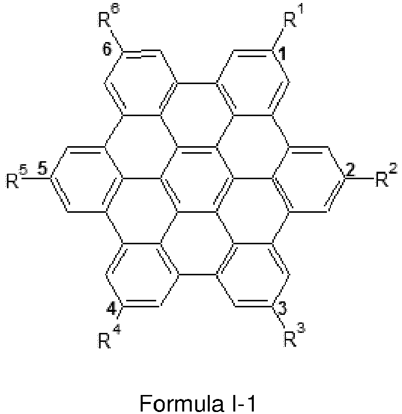 wherein R¹, R³, R⁴ and R⁶ are carboxylic groups and R² and R⁵ have the formula - COO-ZP46, wherein ZP46 has the following formula (2): 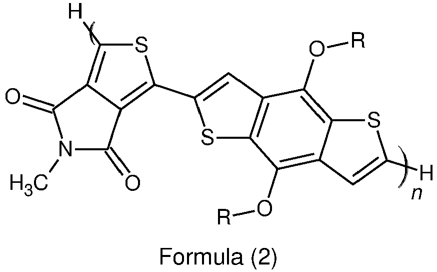 wherein R is methyl or C6H13.

7. Donor:acceptor layer comprising a stack of hexabenzocoronene compounds according to any one of the claims 1 to 6.

8. Device comprising at least one compound based on hexabenzocoronene according to any one of the claims 1 to 6.

9. Device according to claim 8 which is a photovoltaic cell.
